# FASCICULE DE BREVET EUROPEEN

(11) **EP 3 198 220 B1**
(45) Date de publication et mention de la délivrance du brevet: **07.06.2023**
(21) Numéro de dépôt: 15778220.2
(22) Date de dépôt: 18.09.2015
(51) Int. Cl.: G01B 11/24, G01B 9/02, G01N 21/95, H01L 21/66, G01N 21/956

(54) **DISPOSITIF ET PROCEDE DE PROFILOMETRIE DE SURFACE POUR LE CONTROLE DE WAFERS EN COURS DE PROCESS**
VORRICHTUNG UND VERFAHREN ZUR OBERFLÄCHENPROFILOMETRIE ZUR STEUERUNG VON WAFERN WÄHREND DER VERARBEITUNG
DEVICE AND METHOD FOR SURFACE PROFILOMETRY FOR THE CONTROL OF WAFERS DURING PROCESSING

(30) Priorité: 25.09.2014 FR 1459086
(43) Date de publication de la demande: 02.08.2017
(73) Titulaire: Unity Semiconductor, 38330 Montbonnot-Saint-Martin (FR)
(72) Inventeur: FRESQUET, Gilles, F-30190 Garrigues Sainte Eulalie (FR)
(74) Mandataire: IPAZ
(86) Numéro de dépôt international: PCT/EP2015/071407
(87) Numéro de publication internationale: WO 2016/046072

(56) Documents cités:
- WO-A1-2014/029703
- US-A1- 2004 184 038
- US-A1- 2007 148 792
- US-A1- 2013 038 863

## Description

### Domaine technique

La présente invention concerne un dispositif pour effectuer des mesures de profilométrie de surface sur des wafers en cours de process. Elle concerne également un procédé de mesure mis en oeuvre par le dispositif.

Le domaine de l'invention est plus particulièrement mais de manière non limitative celui de la mesure et du contrôle dimensionnel des dispositifs dans le domaine des microsystèmes (MEMs) et en microélectronique.

### Etat de la technique antérieure

Les procédés de fabrications mis en oeuvre en microélectronique reposent en général sur des étapes successives de dépôts de couches et de gravure, qui conduisent à la réalisation de composants sous la forme d'empilements.

Une très bonne planéité des couches est souvent nécessaire. Aussi il est connu de mettre en oeuvre des techniques, notamment de profilométrie optique, pour mesurer cette planéité.

Parmi les techniques de profilométrie optiques, on connaît des techniques dites « en plein champ » qui permettent d'obtenir la forme d'une surface directement en une ou un petit nombre de mesures. On y retrouve notamment des techniques d'interférométrie, qui exploitent des interférences entre un faisceau de mesure réfléchi par la surface à mesurer et un faisceau de référence. Différentes architectures d'interféromètres sont possibles, dont certaines sont connues sous les noms d'interféromètre de Linnik, Mirau, Michelson ou Fizeau.

On connaît également des techniques de profilométrie optique basées sur des mesures de distances ponctuelles avec un faisceau de mesure ponctuel qui balaye la surface. Les techniques de détection mises en oeuvre dans ce cas peuvent notamment comprendre les techniques confocales, confocales chromatiques, ou basées sur de l'interférométrie ou l'interférométrie à faible cohérence (avec des sources à spectre étendu). Elles ont toutefois l'inconvénient d'être beaucoup plus lentes que les techniques en plein champ.

Les documents WO 2014/029703 A1, US 2013/038863 A1 et US 2007/148792 A1 présentent des systèmes pour effectuer des mesures de profilométrie de surfaces de wafers, ainsi que des structures enterrées sous ces surfaces.

Une contrainte commune à toutes ces techniques est que la réflectivité de la surface à mesurer aux longueurs d'ondes de travail doit être élevée pour obtenir de bonnes mesures. Il est en outre nécessaire que les mesures ne soient pas perturbées par des réflexions parasites sur des couches enterrées. Ainsi, on utilise en général des longueurs d'ondes qui pénètrent pas ou peu dans les matériaux (longueurs d'ondes visibles pour le silicium), ou, lorsque les couches à mesurer sont transparentes dans le visible, on y effectue au préalable un dépôt métallique (tantale).

Dans certaines situations, il est nécessaire de mesurer et de caractériser la planéité de couches qui recouvrent des composants ou des puces déjà réalisées, en regard de ces composants. Le problème qui se pose alors est que ces composants ne sont pas visibles depuis la face de mesure. Il est donc difficile de rattacher ou de référencer les mesures de planéité à la position exacte de ces composants, si ce n'est en utilisant des informations à priori sur le design qui sont nécessairement imprécises.

La présente invention a pour objet de proposer un dispositif et un procédé de mesures de profilométrie qui permettent d'effectuer des mesures de forme de surface repérées ou référencées de manière précises par rapport à des composants enterrés dans le wafer ou du moins localisés sous la surface à mesurer.

La présente invention a également pour objet de proposer un dispositif et un procédé de mesures de profilométrie qui permettent d'effectuer des mesures de forme de surface dans un référentiel lié à des composants enterrés dans le wafer ou du moins localisés sous la surface à mesurer.

### Exposé de l'invention

Selon la revendication 1, cet objectif est atteint avec un dispositif pour effectuer des mesures de forme sur une première surface d'un wafer relativement à des structures présentes sous ladite première surface, caractérisé en ce qu'il comprend :
- des moyens de profilométrie avec un interféromètre à champ plein agencés pour effectuer des mesures de forme sur ladite première surface du wafer selon au moins un champ de mesure ;
- des moyens d'imagerie faisant face auxdits moyens de profilométrie et agencés pour acquérir une image de référence desdites structures au travers d'une seconde surface du wafer opposée à la première surface selon au moins un champ d'imagerie ;
lesdits moyens de profilométrie et lesdits moyens d'imagerie étant agencés de sorte que les champs de mesure et d'imagerie sont référencés en position dans un référentiel commun.

Les structures peuvent être par exemple des composants, des pistes ou des puces qui sont enterrées dans les couches du wafer, ou éventuellement réalisées sur la face du wafer opposée à la première surface. Ce sont des structures qui ne sont pas visibles sur la première surface, et donc qui sont sous cette surface du point de vue des moyens de profilométrie.

Les moyens d'imagerie qui font face aux moyens de profilométrie peuvent être localisés vis-à-vis d'une seconde surface, opposée à la première, du wafer à mesurer lorsque celui-ci est positionné dans le dispositif de l'invention. Ils permettent ainsi d'imager les structures, ou du moins d'obtenir des images qui permettent de localiser les structures, et ceci même si ces structures ne sont pas discernables au travers de la première surface.

Selon l'invention, les moyens de profilométrie et les moyens d'imagerie sont calibrés ou référencés spatialement de sorte que la position et l'étendue de leurs champs de mesure et d'imagerie respectifs soient connues l'une par rapport à l'autre, ou en d'autres termes soient référencées dans un même référentiel commun.

De préférence, les champs de mesure et d'imagerie peuvent être représentés sous la forme de plans sensiblement parallèles entre eux. Ils peuvent être référencés dans un référentiel commun sous la forme d'un plan de référence.

Ainsi, il est possible de rattacher ou de relier les mesures de profilométrie à la position des structures sans avoir besoin de connaissances à priori sur la position exacte du wafer dans le dispositif de l'invention.

Suivant des modes de réalisation, le dispositif selon l'invention peut comprendre des moyens d'imagerie aptes à produire des images à des longueurs d'ondes dans l'infrarouge.

Ainsi, il est possible d'imager des structures qui sont « enterrées » dans les couches du wafer, y compris au travers de matériaux non transparents dans les longueurs d'ondes visibles, tel que le silicium.

Il est en particulier possible d'imager des structures au travers du substrat su lesquelles elles sont réalisées.

Le dispositif peut notamment comprendre un interféromètre à champ plein de l'un des types suivants : Michelson, Mirau, Linnik, Fizeau.

Les interféromètres à plein champ sont des interféromètres qui permettent de traiter des signaux de mesures ou des structures d'interférences bidimensionnels, représentatifs d'au moins une partie de la surface à mesurer.

Suivant des modes de réalisation, les moyens de profilométrie et les moyens d'imagerie peuvent avoir des axes optiques sensiblement parallèles.

Suivant des modes de réalisation, les moyens de profilométrie et les moyens d'imagerie peuvent être sont alignés selon un axe optique commun.

Le dispositif selon l'invention peut comprendre en outre un support pour positionner un wafer avec une première face faisant face aux moyens de profilométrie et une seconde face faisant face aux moyens d'imagerie.

Le support de wafer peut comprendre un « chuck ».

Selon la revendication 6, suivant un autre aspect, il est proposé un procédé pour effectuer des mesures de forme sur une première surface d'un wafer relativement à des structures présentes sous ladite première surface, qui comprend des étapes :
- d'acquisition de mesures de forme selon au moins un champ de mesure sur ladite première surface du wafer en mettant en oeuvre des moyens de profilométrie avec un interféromètre à champ plein;
- d'acquisition d'une image de référence des structures selon au moins un champ d'imagerie au travers d'une seconde surface du wafer opposée à la première surface en mettant en oeuvre des moyens d'imagerie faisant face auxdits moyens de profilométrie ;
lesquels champs de mesure et d'imagerie étant référencés en position dans un référentiel commun.

Suivant des modes d'implémentation, le procédé de l'invention peut comprendre en outre une étape d'identification de la position des structures dans l'image de référence.

Il peut comprendre une étape d'acquisition de mesures de forme dans un voisinage d'au moins une position de structure identifiée.

Suivant des modes d'implémentation, le procédé selon l'invention peut comprendre en outre une étape préalable de calibration avec une localisation de la position des champs de mesure et d'imagerie dans un référentiel commun sous la forme d'un plan de référence.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la Fig. 1 illustre un mode de réalisation de dispositif selon l'invention,
- la Fig. 2 illustre un mode de réalisation de profilomètre avec un interféromètre à champ plein de type Michelson,
- la Fig. 3 illustre un mode de réalisation de profilomètre avec un interféromètre à champ plein de type Mirau,
- la Fig. 4 illustre un premier mode de mise en oeuvre du procédé selon l'invention,
- la Fig. 5 illustre un second mode de mise en oeuvre du procédé selon l'invention,
- la Fig. 6 illustre des exemples de mesures obtenus avec le dispositif selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

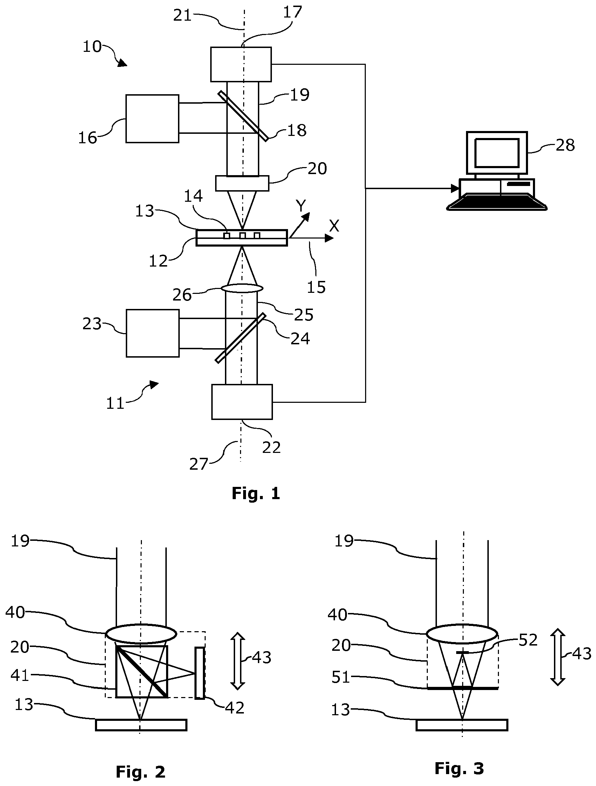

On va tout d'abord décrire, en référence à la Fig. 1, un mode de réalisation de dispositif selon l'invention.

Dans un mode de mise en oeuvre préférentiel, le dispositif selon l'invention est destiné à effectuer des mesures de forme sur une surface 13 d'un wafer 12 qui comprend par ailleurs des structures 14 dans des couches enterrées sous la surface 13.

Le dispositif selon l'invention permet alors de repérer ou de représenter dans un référentiel commun 15 les mesures de forme de la surface 13 et les structures 14 (ou leur position).

Ainsi, à titre d'exemple non limitatif, le dispositif selon l'invention peut être utilisé pour contrôler la planéité d'une couche de contact déposée pardessus ou de sorte à recouvrir des structures 14 réalisées sur le substrat d'un wafer 12. Ces structures 14 peuvent être notamment des circuits intégrés 14. Dans ce cas il est important de contrôler la planéité de la couche de contact précisément au-dessus des circuits intégrés 14. Or cette couche de contact ne permet pas de visualiser la position des circuits intégrés du côté de la surface 13, en particulier si elle est recouverte d'une couche métallique.

Il est alors possible avec le dispositif selon l'invention de visualiser et de localiser les circuits intégrés 14 au travers du substrat qui constitue la partie du wafer 12 opposée à la surface 13 à mesurer, et d'effectuer ou de repérer les mesures de forme par rapport à la position des circuits intégrés 14.

Le dispositif selon l'invention comprend donc des moyens de profilométrie 10 qui permettent d'effectuer des mesures de forme sur la surface 13 du wafer 12, lorsque ce wafer 12 est positionné dans un support de wafer (non représenté sur la Fig. 1).

Le dispositif selon l'invention comprend également des moyens d'imagerie 11 destinés à imager les structures 14 présentes dans ou sous le wafer 12 relativement à la surface 13.

Les moyens de profilométrie 10 et les moyens d'imagerie 11 sont disposés en vis-à-vis, de part et d'autre du wafer 12 lorsque celui-ci est positionné dans le support de wafer.

Le support de wafer est pourvu de moyens de déplacement et translation et/ou en rotation qui permettent de déplacer et de positionner précisément le wafer 12 par rapport aux moyens de profilométrie 10 et d'imagerie 11.

Le pilotage du dispositif et le traitement des données est assuré par un ordinateur 28.

Dans le mode de réalisation présenté, les moyens de profilométrie 10 sont réalisés sous la forme d'un microscope avec un interféromètre à plein champ 20 au niveau de l'objectif, qui constitue ainsi un profilomètre à plein champ 10.

Une source de lumière 16, par exemple à base de diodes électroluminescentes ou de source halogène génère un faisceau d'illumination 19 dans des longueurs d'ondes visibles et/ou proche infrarouge. Ce faisceau d'illumination 19 est dirigé vers l'interféromètre à plein champ 20 par un cube ou une lame séparatrice 18.

Dans l'interféromètre à plein champ 20, le faisceau d'illumination 19 est séparé en un faisceau de référence qui illumine un miroir de référence et un faisceau de mesure qui illumine la surface 13 du wafer 12. La lumière réfléchie respectivement par la surface 13 du wafer et par le miroir de référence est redirigée vers un détecteur matriciel 17, par exemple de type CCD ou CMOS.

Le profilomètre 10 comprend des optiques et des lentilles, dont un objectif d'imagerie, agencés de sorte à imager la surface 13 du wafer sur le détecteur matriciel 17. Lorsque la différence de trajets optiques entre le faisceau de mesure et le faisceau de référence est inférieure à la longueur de cohérence de la source de lumière 16, des franges d'interférences dues aux interférences entre le faisceau de mesure et le faisceau de référence sont également visibles. La démodulation de ces franges d'interférences, selon des techniques connues de l'homme du métier, permet de reconstruire la forme de la surface 13 selon un champ de mesure correspondant sensiblement à la zone de cette surface 13 imagée sur le détecteur 17.

Il existe différentes sortes d'interféromètres à plein champ 20 utilisables dans le cadre de l'invention.

En référence à la Fig. 2, l'interféromètre à plein champ 20 peut être réalisé selon la configuration de Michelson. Il comprend alors un cube séparateur 41 (ou une lame séparatrice) disposé entre un objectif d'imagerie 40 et la surface 13 à mesurer. Ce cube séparateur 41 renvoie une fraction du faisceau d'éclairage incident 19 vers un miroir de référence 42 pour générer le faisceau de référence.

En référence à la Fig. 3, l'interféromètre à plein champ 20 peut également être réalisé selon la configuration de Mirau. Il comprend alors une lame séparatrice semi-réfléchissante 51 positionnée entre un objectif d'imagerie 40 et la surface 13 à mesurer. Cette lame séparatrice renvoie une partie de la lumière incidente vers un miroir de référence 52 positionné au centre du faisceau d'illumination.

L'interféromètre à plein champ peut également être réalisé selon une configuration de Linnik. Cette configuration est une variante de la configuration de Michelson dans laquelle on introduit un objectif d'imagerie dans chaque bras de l'interféromètre. Dans ce cas, le cube séparateur 41 se trouve avant l'objectif d'imagerie dans le faisceau d'illumination.

Bien entendu, d'autres configurations d'interféromètres à plein champ 20 sont également possibles dans le cadre de l'invention.

Le profilomètre comprend également des moyens de translation 43, réalisés par exemple en mettant en oeuvre un actuateur piézo-électrique, qui permettent de déplacer de manière très précise l'ensemble constitué de l'interféromètre 20 et de l'objectif d'imagerie 40 par rapport à la surface à mesurer 13. Ces moyens de translation 43 permettent de faire varier le chemin optique du faisceau de mesure entre l'élément séparateur (par exemple le cube séparateur 41 de la Fig. 2 ou la lame séparatrice 51 de la Fig. 3) et la surface à mesurer 13, sans modifier le trajet optique du faisceau de référence entre cet élément séparateur et le miroir de référence. On peut ainsi faire varier la phase de la structure d'interférences obtenue sur le détecteur 17 d'une manière connue ou maîtrisée, et mettre en oeuvre des algorithmes de reconstruction de type « phase stepping » qui permettent de reconstruire la forme de la surface 13 d'une manière très précise et non ambigüe sur la base de séquences d'images acquises avec des conditions de déphasage différentes.

Les moyens d'imagerie 11 sont réalisés sous la forme d'un microscope d'imagerie avec une source d'illumination 23, un objectif d'imagerie 26, un détecteur matriciel 27 (de type CCD ou CMOS par exemple), et un élément séparateur 24 de type lame ou cube séparateur (par exemple).

La lumière 25 de la source d'illumination 23 est dirigée vers la face arrière du wafer par l'élément séparateur 24. La lumière réfléchie par le wafer 21 et collectée par l'objectif d'imagerie 26 est transmise vers le détecteur matriciel 27. Le système optique avec l'objectif d'imagerie 26 est agencé de sorte à permettre la formation d'une image du wafer sur le détecteur matriciel 22 selon un champ d'imagerie.

La source de lumière 23 est conçue de sorte à présenter un spectre d'émission s'étendant dans le proche infrarouge jusqu'à des longueurs d'ondes supérieures à 1 micromètre, pour lesquelles le silicium n'est plus totalement opaque. Cette source de lumière 23 peut être une source halogène. Il est alors possible, même avec un détecteur matriciel 22 à base de silicium, d'obtenir une image des structures 14 du wafer 12 au travers d'une couche de silicium telle que le substrat.

Comme expliqué précédemment, les moyens de profilométrie 10 et les moyens d'imagerie 11 sont agencés de sorte que les champs de mesure et d'imagerie soient référencés en position dans un référentiel commun 15.

Pour cela, les moyens de profilométrie 10 et les moyens d'imagerie 11 sont solidaires d'un support qui permet de les maintenir et/ou de les positionner d'une manière précise et stable les uns par rapport aux autres.

Ils sont en outre agencés de sorte que l'axe optique 21 des moyens de profilométrie 10 et l'axe optique 27 des moyens d'imagerie 11 coïncident sensiblement, ou du moins soient proches et sensiblement parallèles. De cette manière, les champs de mesure et d'imagerie sont sensiblement superposés au niveau du wafer 12, et on évite les erreurs de parallaxe dues à l'épaisseur du wafer.

Le dispositif est ensuite calibré, par exemple au moyen d'un échantillon ou d'un wafer 12 de calibration qui comprend des motifs sur les deux faces dont les positions les unes par rapport aux autres sont connues. Il est à noter que comme le profilomètre 10 est également un système d'imagerie, la calibration peut être effectuée simplement en imagerie avec un wafer 12 qui comprend des motifs visibles sur les deux faces.

On peut ainsi localiser les champs de mesure et d'imagerie dans un référentiel commun 15 à deux dimensions (X-Y), ou plan de référence. En effet, il n'est pas nécessaire de connaître les différences de hauteur (relativement à l'épaisseur du wafer 12) entre les mesures de profilométrie et d'imagerie, pour autant qu'on ait pris la précaution de positionner les axes optiques 21, 27 des moyens de profilométrie et d'imagerie de manière sensiblement parallèle.

On peut par exemple attacher le plan de référence 15 au champ d'imagerie qui permet de localiser les structures 14 du wafer, et calculer par calibration une fonction de transfert dans le plan (à base de translations, rotations et homothéties) qui permet de localiser les pixels du champ de mesure dans le champ d'imagerie.

Le dispositif de l'invention permet d'acquérir et de traiter des mesures de différentes façons.

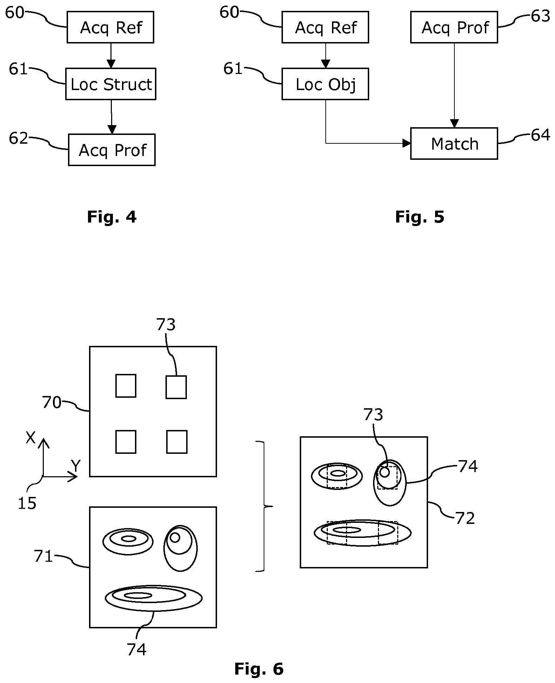

A titre d'exemple, la Fig. 4 présente un procédé de mesure de formes de surface selon l'invention qui comprend :
- une étape d'acquisition 60 d'une image de référence avec les moyens d'imagerie 11 ;
- une étape d'identification 61 de la position des structures 14 du wafer 12 (et éventuellement de leur forme) dans l'image de référence, en mettant en oeuvre par exemple des techniques de segmentation d'images connues ;
- une étape 62 d'acquisition avec le profilomètre 10 de la forme de la surface 13 du wafer dans une ou des zone(s) correspondant à la position des structures 14 identifiées, compte tenu de la fonction de transfert obtenue lors de la calibration.

A titre d'exemple également, la Fig. 5 présente un procédé de mesure de profil selon l'invention qui comprend :
- une étape d'acquisition 60 d'une image de référence 70 selon un champ d'imagerie avec les moyens d'imagerie 11 ;
- une étape d'identification 61 de la position des structures 14 du wafer 12 (et éventuellement de leur forme) dans l'image de référence, en mettant en oeuvre par exemple des techniques de segmentation d'images connues ;
- une étape 63 d'acquisition de la forme de la surface 13 du wafer avec le profilomètre 10 dans un champ de mesure au moins en partie superposé au champ d'imagerie utilisé au niveau du wafer 12 ;
- une étape 64 de mise en correspondance des mesures de forme et des structures 14 en utilisant la fonction de transfert obtenue lors de la calibration.

Dans ce mode de réalisation l'étape d'identification 61 des structures peut être omise si l'on ne recherche qu'une correspondance visuelle.

La Fig. 6 illustre des résultats de mesures qu'il est possible d'obtenir avec l'invention, notamment dans le mode de mise en oeuvre décrit en relation avec la Fig. 5. Elle présente :
- une image 70 obtenue avec les moyens d'imagerie 11 avec une représentation 73 des structures 14 du wafer 12;
- une représentation 71 de la forme de la surface 13 du wafer 12, obtenue avec les moyens de profilométrie 10 et dans laquelle la forme surface est représentée en courbes de niveaux 74 ;
- une image 72 combinant la représentation en courbes de niveau 74 de la forme de la surface, après recalage dans le référentiel 15 de l'image 70, et les représentations 73 des structures 14.

On peut ainsi bien visualiser les défauts de planéités de la surface 13 du wafer 12 par rapport aux structures 14.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif pour effectuer des mesures de forme sur une première surface (13) d'un wafer (12) relativement à des structures (14) présentes sous ladite première surface (13), **caractérisé en ce qu'**il comprend :
- des moyens de profilométrie (10) avec un interféromètre à champ plein (20) agencés pour effectuer des mesures de forme sur ladite première surface (13) du wafer (12) selon au moins un champ de mesure ;
- des moyens d'imagerie (11) faisant face auxdits moyens de profilométrie (10) et agencés pour acquérir une image de référence desdites structures (14) au travers d'une seconde surface du wafer (12) opposée à la première surface (13) selon au moins un champ d'imagerie ;
lesdits moyens de profilométrie (10) et lesdits moyens d'imagerie (11) étant agencés de sorte que les champs de mesure et d'imagerie sont référencés en position dans un référentiel commun (15).

2. Le dispositif de la revendication 1, qui comprend des moyens d'imagerie (11) aptes à produire des images à des longueurs d'ondes dans l'infrarouge.

3. Le dispositif de l'une des revendications 1 ou 2, qui comprend un interféromètre à champ plein (20) de l'un des types suivants : Michelson, Mirau, Linnik, Fizeau.

4. Le dispositif de l'une des revendications précédentes, dans lequel les moyens de profilométrie (10) et les moyens d'imagerie (11) ont des axes optiques (21, 27) sensiblement parallèles.

5. Le dispositif de l'une des revendications précédentes, qui comprend en outre un support pour positionner un wafer (12) avec une première face (13) faisant face aux moyens de profilométrie (10) et une seconde face faisant face aux moyens d'imagerie (11).

6. Procédé pour effectuer des mesures de forme sur une première surface (13) d'un wafer (12) relativement à des structures (14) présentes sous ladite première surface (13), **caractérisé en ce qu'**il comprend des étapes:
- d'acquisition de mesures de forme selon au moins un champ de mesure sur ladite première surface (13) du wafer (12) en mettant en oeuvre des moyens de profilométrie (10) avec un interféromètre à champ plein (20);
- d'acquisition d'une image de référence des structures (14) selon au moins un champ d'imagerie au travers d'une seconde surface du wafer (12) opposée à la première surface (13) en mettant en oeuvre des moyens d'imagerie (11) faisant face auxdits moyens de profilométrie (10);
lesquels champs de mesure et d'imagerie étant référencés en position dans un référentiel commun (15).

7. Le procédé de la revendication 6, qui comprend en outre une étape d'identification de la position des structures (14) dans l'image de référence.

8. Le procédé de la revendication 7, qui comprend une étape d'acquisition de mesures de forme dans un voisinage d'au moins une position de structure identifiée.

9. Le procédé de l'une des revendications 6 à 8, qui comprend en outre une étape préalable de calibration avec une localisation de la position des champs de mesure et d'imagerie dans un référentiel commun (15) sous la forme d'un plan de référence.

## Patentansprüche

1. Vorrichtung, um Formmessungen an einer ersten Oberfläche (13) eines Wafers (12) bezüglich unter der ersten Oberfläche (13) vorhandenen Strukturen (14) durchzuführen, **dadurch gekennzeichnet, dass** sie umfasst:
- Profilometrie-Mittel (10) mit einem Feld-Interferometer (20), die dazu vorgesehen sind, Formmessungen an der ersten Oberfläche (13) des Wafers (12) gemäß mindestens einem Messfeld durchzuführen;
- Bildgebungsmittel (11), die den Profilometrie-Mitteln (10) gegenüberliegen und dazu vorgesehen sind, ein Referenzbild der Strukturen (14) durch eine zweite Oberfläche des Wafers (12), die der ersten Oberfläche (13) gegenüberliegt, gemäß mindestens einem Bildgebungsfeld zu erfassen;
wobei die Profilometrie-Mittel (10) und die Bildgebungsmittel (11) derart angeordnet sind, dass die Mess- und Bildgebungsfelder in einem gemeinsamen Bezugssystem (15) bezüglich ihrer Position referenziert sind.

2. Vorrichtung nach Anspruch 1, umfassend Bildgebungsmittel (11), die geeignet sind, Bilder in Wellenlängen im Infrarotbereich zu erzeugen.

3. Vorrichtung nach einem der Ansprüche 1 oder 2, umfassend ein Feld-Interferometer (20) eines der folgenden Typen: Michelson, Mirau, Linnik, Fizeau.

4. Vorrichtung nach einem der vorhergehenden Ansprüche, bei der die Profilometrie-Mittel (10) und die Bildgebungsmittel (11) im Wesentlichen parallele optische Achsen (21, 27) haben.

5. Vorrichtung nach einem der vorhergehenden Ansprüche, ferner umfassend einen Träger, um einen Wafer (12) mit einer ersten Seite (13), die den Profilometrie-Mitteln (10) gegenüberliegt, und einer zweiten Seite, die den Bildgebungsmitteln (11) gegenüberliegt, zu positionieren.

6. Verfahren, um Formmessungen an einer ersten Oberfläche (13) eines Wafers (12) bezüglich unter der ersten Oberfläche (13) vorhandenen Strukturen (14) durchzuführen, **dadurch gekennzeichnet, dass** es die folgenden Schritte umfasst:
- Erfassung von Formmessungen gemäß mindestens einem Messfeld an der ersten Oberfläche (13) des Wafers (12), wobei Profilometrie-Mittel (10) mit einem Feld-Interferometer (20) eingesetzt werden;
- Erfassung eines Referenzbildes der Strukturen (14) gemäß mindestens einem Bildgebungsfeld durch eine zweite Oberfläche des Wafers (12), die der ersten Oberfläche (13) gegenüberliegt, wobei Bildgebungsmittel (11) eingesetzt werden, die den Profilometrie-Mitteln (10) gegenüberliegen;
wobei die Mess- und Bildgebungsfelder in einem gemeinsamen Bezugssystem (15) bezüglich ihrer Position referenziert sind.

7. Verfahren nach Anspruch 6, ferner umfassend einen Schritt der Identifikation der Position der Strukturen (14) in dem Referenzbild.

8. Verfahren nach Anspruch 7, umfassend einen Schritt der Erfassung von Formmessungen in der Nähe mindestens einer Position einer identifizierten Struktur.

9. Verfahren nach einem der Ansprüche 6 bis 8, ferner umfassend einen vorherigen Kalibrierungsschritt mit einer Lokalisierung der Position der Mess- und Bildgebungsfelder in einem gemeinsamen Bezugssystem (15) in Form einer Referenzebene.

## Claims

1. Device for carrying out measurements of shape on a first surface (13) of a wafer (12) relative to structures (14) present beneath said first surface (13), **characterized in that** it comprises:
- profilometry means (10) with a full-field interferometer (20) arranged in order to carry out measurements of shape on said first surface (13) of the wafer (12) according to at least one measurement field;
- imaging means (11) facing said profilometry means (10) and arranged in order to acquire a reference image of said structures (14) through a second surface of the wafer (12) opposite to the first surface (13) according to at least one imaging field;
said profilometry means (10) and said imaging means (11) being arranged so that the measurement and imaging fields are referenced in position within a common frame of reference (15).

2. The device according to claim 1, comprising imaging means (11) capable of producing images at wavelengths in the infrared.

3. The device according to one of claims 1 or 2, comprising a full-field interferometer (20) of one of the following types: Michelson, Mirau, Linnik, Fizeau.

4. The device according to one of the preceding claims, in which the profilometry means (10) and the imaging means (11) have substantially parallel optical axes (21, 27).

5. The device according to one of the preceding claims, also comprising a support for positioning a wafer (12) with a first face (13) facing profilometry means (10) and a second face facing imaging means (11).

6. Method for carrying out measurements of shape on a first surface (13) of a wafer (12) relative to structures (14) present beneath said first surface (13), **characterized in that** it comprises the following steps:
- acquiring measurements of shape according to at least one measurement field on said first surface (13) of the wafer (12) by implementing profilometry means (10) with a full-field interferometer (20);
- acquiring a reference image of the structures (14) according to at least one imaging field through a second surface of the wafer (12) opposite to the first surface (13), implementing imaging means (11) facing said profilometry means (10);
said measurement and imaging fields are referenced in position within a common frame of reference (15).

7. The method according to claim 6, also comprising a step of identification of the position of the structures (14) in the reference image.

8. The method according to claim 7, comprising a step of acquiring measurements of shape in proximity to at least one identified structure position.

9. The method according to one of claims 6 to 8, also comprising a prior step of calibration with location of the position of the measurement and imaging fields within a common frame of reference (15) in the form of a reference plane.
